# DEMANDE DE BREVET EUROPEEN

(11) **EP 2 045 911 A1**
(43) Date de publication de la demande: **08.04.2009**
(21) Numéro de dépôt: 07117967.5
(22) Date de dépôt: 05.10.2007
(51) Int. Cl.: H03C 3/09

(54) **Procédé d'auto-calibrage d'un synthétiseur de fréquence à modulation FSK à deux points**

(71) Demandeur: The Swatch Group Research and Development Ltd., 2074 Marin (CH)
(72) Inventeur: Casagrande, Arnaud, 2068 Hauterive (CH)
(74) Mandataire: Couillard, Yann Luc Raymond

(57) **Abrégé**

Le synthétiseur de fréquence (1) pour la mise en oeuvre du procédé d'auto-calibrage comprend une première boucle à verrouillage de phase et un accès haute fréquence, qui comprend un convertisseur numérique-analogique (20) à calibrer par le procédé, relié à une seconde entrée d'un oscillateur commandé en tension. La première boucle à verrouillage de phase comprend un oscillateur de référence (2), un comparateur de phase (3), une première pompe de charges (4), un premier filtre de boucle (5), l'oscillateur commandé en tension (10) relié par une première entrée dans la première boucle, un compteur diviseur multi-mode (9) commandé par un modulateur (11) et relié au comparateur de phase. Pour l'opération de calibrage, le synthétiseur de fréquence comprend une seconde pompe de charges (14) reliée au comparateur de phase (3), et un second filtre de boucle (15) dans l'accès haute fréquence. Lorsque la seconde pompe de charges est mise en fonction, elle constitue avec le second filtre relié à l'oscillateur commandé en tension une second boucle à verrouillage de phase. Un comparateur de tension (21) compare une tension de sortie du convertisseur numérique-analogique (20) avec une tension sur le second filtre de boucle afin de calibrer le gain du convertisseur, lorsque la seconde boucle à verrouillage de phase est verrouillée sur une fréquence de sortie déterminée.

## Description

L'invention concerne un procédé d'auto-calibrage d'un synthétiseur de fréquence à modulation FSK du type à deux points pour la transmission de données. Le synthétiseur de fréquence comprend une première boucle à verrouillage de phase basse fréquence dans laquelle est placé un oscillateur commandé en tension, et un accès haute fréquence, qui comprend un convertisseur numérique-analogique, relié à l'oscillateur commandé en tension. La première boucle à verrouillage de phase comprend également un oscillateur de référence, un comparateur de phase relié à l'oscillateur de référence, un premier filtre de boucle passe-bas, et un compteur diviseur multi-mode commandé par un modulateur pour fournir au comparateur de phase un signal divisé sur la base d'un signal haute fréquence de sortie du synthétiseur. L'oscillateur commandé en tension est commandé à une première entrée par un premier signal de tension de commande provenant du premier filtre de boucle, et à une seconde entrée par un second signal de tension de commande pour la modulation de données haute fréquence.

L'invention concerne également un synthétiseur de fréquence à modulation FSK du type à deux points pour la mise en oeuvre du procédé d'auto-calibrage.

On définit une modulation de fréquence du type à deux points par l'addition de la contribution d'un chemin haute fréquence avec un convertisseur numérique-analogique et d'un chemin basse fréquence dans une boucle à verrouillage de phase basse fréquence au niveau de l'oscillateur commandé en tension. Lors de transitions d'état haute fréquence, le chemin haute fréquence est primordial, alors que pour des transitions d'état basse fréquence le chemin basse fréquence devient primordial. Toutefois les deux chemins contribuent à la modulation de données en fréquence pour couvrir une largeur de bande déterminée, qui s'étend en haute fréquence de modulation.

Dans le document de brevet EP 0 961 412, il est décrit un synthétiseur de fréquence pour une modulation de fréquence à deux points pour la transmission de données. Ce synthétiseur de fréquence utilise un modulateur du type sigma delta pour la modulation de données en commandant un diviseur variable dans la boucle à verrouillage de phase basse fréquence, et un convertisseur numérique-analogique DAC pour la modulation haute fréquence. Ce convertisseur DAC a un gain variable, qui est réglé par une unité à commande numérique, et est commandé par un signal de commande numérique pour la modulation en fréquence des données. Ce signal de commande numérique est également transmis au modulateur sigma delta pour combiner la modulation de la boucle basse fréquence et celle fournie par le convertisseur DAC.

Dans ce synthétiseur, il est opéré une variation du retard relatif du signal de modulation passant par le convertisseur DAC par rapport à la modulation dans la boucle basse fréquence. Cependant, rien n'est décrit dans ce document concernant l'adaptation du niveau d'amplitude du spectre des données modulées par la boucle à verrouillage de phase basse fréquence et par l'intermédiaire du convertisseur DAC. De ce fait, il peut survenir des interférences non désirées en fonction de la fréquence de transition d'état pour la transmission des données.

Dans le document de brevet US 2003/0043950, il est également décrit un synthétiseur de fréquence à boucle à verrouillage de phase et à modulation de fréquence à deux points. Ce synthétiseur de fréquence comprend en plus d'une boucle à verrouillage de phase basse fréquence et d'un modulateur sigma delta, un convertisseur numérique-analogique DAC dont la sortie agit directement sur l'oscillateur commandé en tension VCO. Les données sont d'une part modulées à une première entrée de l'oscillateur commandé en tension VCO par l'intermédiaire du diviseur multi-mode commandé par le modulateur, et à une seconde entrée de l'oscillateur VCO par le convertisseur DAC. Grâce à la modulation à deux points, ce synthétiseur de fréquence permet d'éviter l'atténuation des données modulées haute fréquence due à la largeur de bande étroite de la boucle à verrouillage de phase.

Même si le gain du convertisseur DAC peut être ajusté, il n'est pas prévu d'égaliser le niveau d'amplitude du spectre des données modulées dans la boucle basse fréquence et dans le convertisseur numérique-analogique. Ceci peut conduire comme pour le synthétiseur de fréquence précédent à certains problèmes de distorsion lors de la transition d'état pour la modulation des données.

L'invention a donc pour but de fournir un procédé d'auto-calibrage d'un synthétiseur de fréquence qui permet d'égaliser le niveau d'amplitude du spectre des données modulées par le convertisseur numérique-analogique combiné avec la première boucle à verrouillage de phase basse fréquence. Ceci permet d'éviter d'avoir des distorsions lors de transitions haute fréquence d'état des données à transmettre ou des retards de transition d'état par la boucle basse fréquence.

A cet effet, l'invention concerne un procédé d'auto-calibrage d'un synthétiseur de fréquence, qui comprend les caractéristiques mentionnées dans la revendication indépendante 1.

Des étapes particulières du procédé d'auto-calibrage sont définies dans les revendications dépendantes 2 à 9.

Un avantage d'un tel procédé d'auto-calibrage selon l'invention réside dans le fait que le convertisseur numérique-analogique peut être automatiquement calibré en ajustant son gain en comparant la tension sur un second filtre de boucle dans l'accès haute fréquence d'une seconde boucle à verrouillage de phase en fonction, et la tension de sortie dudit convertisseur. Ce gain du convertisseur est ajusté après avoir effectué une première phase de verrouillage de la première boucle à verrouillage de phase sur un canal de transmission à fréquence porteuse déterminée, et fourni un premier mot de commande en entrée du convertisseur pour correspondre à cette fréquence porteuse. La comparaison de tension dans l'accès haute fréquence est effectuée dans une deuxième phase sur la base d'un second mot de commande fourni au convertisseur correspondant à une première fréquence de sortie haute de modulation. Ceci permet de calibrer l'écart de tension en sortie du convertisseur pour une déviation de fréquence de modulation identique entre la première boucle à verrouillage de phase et l'accès haute fréquence.

Avantageusement, une troisième phase du procédé d'auto-calibrage permet de calibrer le convertisseur numérique-analogique sur la base d'une comparaison d'une tension sur le second filtre de boucle de la seconde boucle à verrouillage de phase fermée correspondant à une seconde fréquence de sortie basse de modulation. Pour ce faire, un troisième mot de commande est fourni au convertisseur afin de comparer la tension de sortie dudit convertisseur avec la tension sur le second filtre de boucle pour ajuster à nouveau le gain du convertisseur. La modulation de fréquence pour la transmission de données peut être avantageusement effectuée par commutation entre la première fréquence de sortie et la seconde fréquence de sortie autour de la fréquence porteuse.

L'invention a également pour but de fournir un synthétiseur de fréquence à modulation de fréquence à deux points, qui comprend des moyens pour égaliser le niveau d'amplitude du spectre des données modulées par le convertisseur numérique-analogique combiné avec la première boucle à verrouillage de phase.

A cet effet, l'invention concerne un synthétiseur de fréquence pour la mise en oeuvre du procédé d'auto-calibrage, qui comprend les caractéristiques mentionnées dans la revendication indépendante 10.

Des formes d'exécution avantageuses du synthétiseur de fréquence sont définies dans les revendications dépendantes 11 à 18.

Les buts, avantages et caractéristiques du procédé d'auto-calibrage d'un synthétiseur de fréquence à modulation de fréquence à deux points, et du synthétiseur de fréquence pour sa mise en oeuvre apparaîtront mieux dans la description suivante sur la base d'au moins une forme d'exécution non limitative illustrée par les dessins sur lesquels :
la figure 1 représente de manière simplifiée une forme d'exécution d'un synthétiseur de fréquence pour une modulation de fréquence à deux points selon l'invention,
les figures 2a à 2d représentent les différentes étapes du procédé d'auto-calibrage en montrant clairement les différents éléments en fonction du synthétiseur de fréquence à modulation de fréquence à deux points de

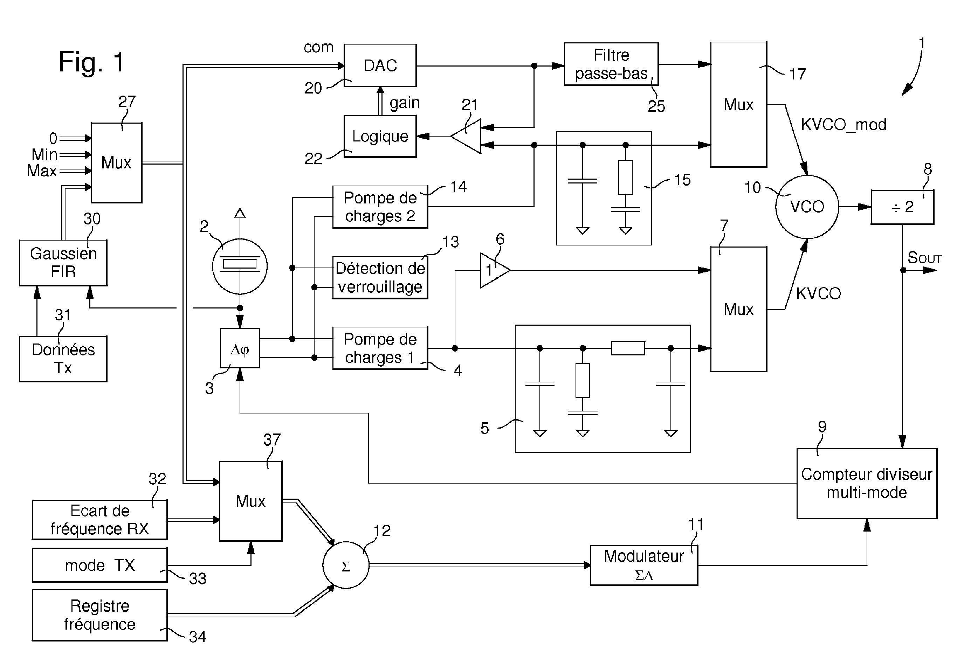

la figure 1 pour chaque étape du procédé selon l'invention,

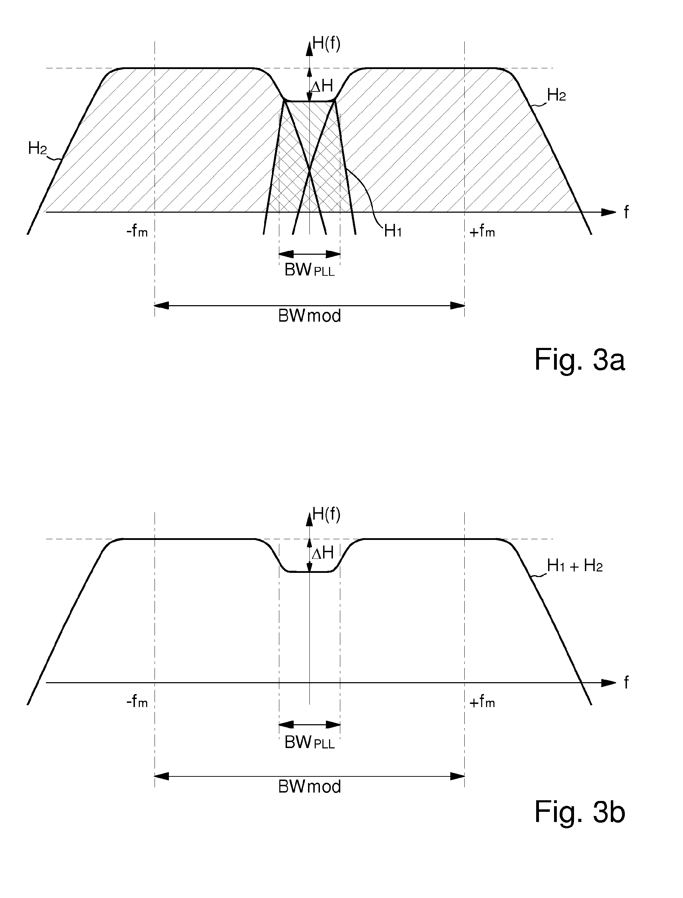

les figures 3a et 3b représentent des graphiques des fonctions de transfert ou du spectre des données modulées par la première boucle à verrouillage de phase basse fréquence et par l'accès haute fréquence du synthétiseur de fréquence à deux points, et

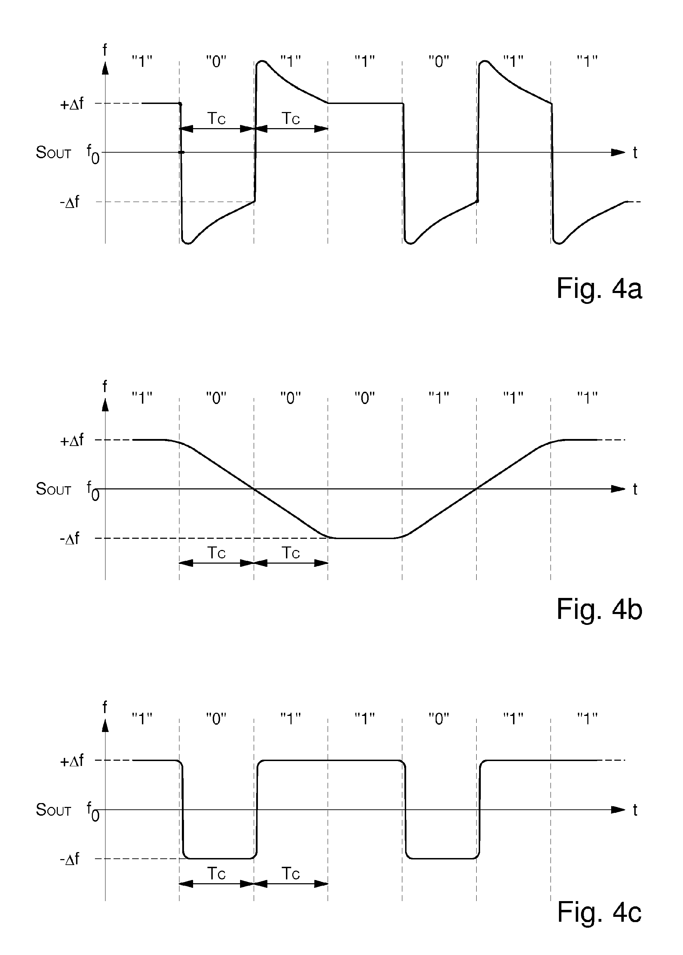

les figures 4a à 4c représentent des graphiques de la modulation de fréquence dans le temps avec des distorsions ou des retards du signal apparaissant lorsque le gain du convertisseur numérique-analogique n'est pas calibré comme montré dans les figures 4a et 4b.

Dans la description suivante, tous les composants du synthétiseur de fréquence à modulation de fréquence (FSK) à deux points, qui sont bien connus d'un homme du métier dans ce domaine technique, ne sont décrits que de manière simplifiée. Il est spécifiquement précisé tous les éléments du synthétiseur de fréquence qui permettent de mettre en oeuvre le procédé d'auto-calibrage pour égaliser le niveau d'amplitude du spectre de données modulées par le synthétiseur de fréquence.

A la figure 1, il est représenté une forme d'exécution préférée d'un synthétiseur de fréquence 1 à modulation de fréquence du type à deux points. Ce synthétiseur de fréquence peut servir notamment pour la transmission de données modulées en fréquence dans un signal radiofréquence. Le synthétiseur de fréquence peut constituer une partie importante d'un transmetteur GFSK travaillant dans une bande de fréquence proche de 2.45 GHz. Ce synthétiseur de fréquence peut être réalisé dans une technologie CMOS à 0.18 µm par exemple.

Le synthétiseur de fréquence 1 comprend principalement une première boucle à verrouillage de phase basse fréquence ou passe-bas, et un accès haute fréquence relié à un oscillateur commandé en tension VCO 10 de la première boucle à verrouillage de phase. L'accès haute fréquence comprend un convertisseur numérique-analogique 20 et des moyens pour calibrer automatiquement le gain du convertisseur comme expliqué ci-dessous. Une précision de fréquence est obtenue par l'intermédiaire de la première boucle à verrouillage de phase basse fréquence, et la rapidité de commutation est obtenue par l'accès haute fréquence. Pour des transitions d'état haute fréquence lors de la modulation de données, l'accès haute fréquence est ainsi principalement utilisé, alors que pour des transitions d'état basse fréquence, la première boucle à verrouillage de phase plus précise est utilisée.

La première boucle à verrouillage de phase basse fréquence comprend tout d'abord un oscillateur de référence 2, qui peut être de préférence un oscillateur à quartz, pour fournir un signal de référence, ayant une fréquence située entre 16 et 26 MHz, à un comparateur de phase 3. Un premier filtre de boucle passe-bas 5 est relié au comparateur de phase par l'intermédiaire d'une première pompe de charges 4, qui constitue une partie de moyens de connexion. Deux fils relient le comparateur de phase 3 à la première pompe de charges pour fournir un signal numérique haut et bas bien connu à la première pompe de charges 4. Le courant de polarisation de cette pompe de charges typique peut être situé au voisinage de 3 pA.

L'oscillateur commandé en tension VCO 10, qui peut être un varacteur dédicacé, est relié par une première entrée à grande sensibilité par exemple de l'ordre de 400 MHz/V dans la première boucle à verrouillage de phase. La première entrée de l'oscillateur commandé en tension peut recevoir un premier signal de tension de commande KVCO par l'intermédiaire du premier filtre de boucle 5. Ce filtre de boucle peut être un filtre passe-bas du deuxième ordre comme montré par l'agencement des trois condensateurs (p. ex. 20 pF, 200 pF, 10 pF) et deux résistances (p. ex. 100 kOhm, 16 kOhm) du bloc du filtre passe-bas 5. La fréquence de coupure de ce premier filtre de boucle peut être choisi à 100 kHz en fonction de la fréquence de l'oscillateur de référence 2.

L'oscillateur commandé en tension 10 est susceptible de générer un signal haute fréquence dont la fréquence peut être voisine de 5 GHz. Cependant la transmission des données modulées du transmetteur GFSK est opérée sur une fréquence porteuse d'un canal de transmission proche de 2.45 GHz. De ce fait, l'oscillateur commandé en tension 10 est suivi dans la première boucle à verrouillage de phase par un diviseur par deux 8 afin de fournir un signal de sortie haute fréquence S_{OUT} comprenant des données modulées à transmettre.

Le signal de sortie haute fréquence S_{OUT} est divisé par un compteur diviseur multi-mode 9 commandé par un modulateur, tel qu'un modulateur sigma delta 11 bien connu. Ce modulateur sigma delta peut être réalisé sur la base d'une structure basique MASH 1-1-1 du troisième ordre. Le compteur diviseur multi-mode 9 fournit un signal divisé par un facteur N-fractionnel au comparateur de phase 3 de la première boucle à verrouillage de phase de manière à être comparé au signal de référence de l'oscillateur de référence 2.

Pour la mise en oeuvre du procédé d'auto-calibrage, la première boucle à verrouillage de phase comprend encore en parallèle du premier filtre de boucle 5, un suiveur de tension unitaire 6, dont l'entrée est reliée entre la sortie de la première pompe de charges 4 et le premier filtre de boucle 5. Un premier multiplexeur 7 reçoit à une première entrée un signal de tension du suiveur de tension unitaire 6 et à une seconde entrée un signal de tension du premier filtre de boucle 5. La sortie du premier multiplexeur est reliée directement à la première entrée de l'oscillateur commandé en tension 10 pour fournir le premier signal de tension de commande KVCO. Le premier signal de tension de commande KVCO provient soit directement du premier filtre de boucle 5, soit directement du suiveur de tension en fonction de l'état d'un signal de commande fourni au premier multiplexeur non représenté.

Comme il sera expliqué par la suite, le suiveur de tension unitaire 6 est utilisé dans le procédé d'auto-calibrage notamment lorsque la première pompe de charges est mise hors fonction. Dans ce cas, le varacteur de l'oscillateur commandé en tension 10 perd un peu de courant, ce qui est compensé par le suiveur de tension, afin que la tension sur le premier filtre de boucle 5 reste constante pour fournir le premier signal de tension de commande KVCO. Cependant une fois l'opération de calibrage terminée, le suiveur de tension unitaire 6 doit être déconnecté pour la modulation des données.

Le retrait du suiveur de tension est nécessaire pour des raisons de stabilité, car la largeur de bande du suiveur doit être au moins 10 fois la fréquence de coupure du premier filtre de boucle, qui est de l'ordre de 100 kHz. De plus, le bruit généré par le suiveur de tension unitaire 6 est converti en bruit de phase, ce qui peut être un problème avec le large gain dans l'oscillateur commandé en tension 10 lié au premier signal de tension de commande KVCO.

La première boucle à verrouillage de phase peut comprendre une double structure différentielle non représentée entre la première pompe de charges 4 et l'oscillateur commandé en tension 10. Cette double structure peut être composée de deux premiers filtres de boucle et de deux suiveurs de tension unitaire en parallèle. Le premier multiplexeur peut ainsi relier soit les sorties des deux suiveurs de tension unitaire, soit les sorties des deux premiers filtres de boucle à la première entrée différentielle de l'oscillateur commandé en tension. Grâce à la double structure différentielle en sortie de la première pompe de charges 4, la première boucle à verrouillage de phase basse fréquence est ainsi isolée des perturbations pouvant survenir. Ces perturbations peuvent ainsi être annulées, ce qui peut être important du fait de la grande sensibilité (400 MHz/V) à la première entrée de l'oscillateur commandé en tension 10. La fréquence porteuse du canal de transmission sélectionné est générée précisément par l'intermédiaire de la première boucle à verrouillage de phase.

L'accès haute fréquence du synthétiseur de fréquence 1 pour la modulation de fréquence à deux points, comprend donc le convertisseur numérique-analogique 20. Ce convertisseur numérique-analogique 20 pourrait être implémenté avec des sources de courant commutées et une charge active en poly-résistance OTA. Le convertisseur reçoit en entrée un mot de commande com pour correspondre à une fréquence désirée à synthétiser par l'intermédiaire de la première boucle à verrouillage de phase. Le convertisseur numérique-analogique 20 fournit en sortie un signal de tension dont le niveau dépend du mot de commande com fourni à l'entrée, et du gain dudit convertisseur à calibrer.

Le signal de tension en sortie du convertisseur numérique-analogique est filtré dans un filtre passe-bas 25, qui est un filtre anti-repliement susceptible de supprimer des fréquences images dans le spectre des données modulées autour de n fois la fréquence d'horloge du convertisseur. Cette fréquence d'horloge peut être par exemple identique à la fréquence du signal de référence. Ce filtre passe-bas 25 peut être constitué par une simple structure RC du premier ordre, car un premier filtrage est déjà effectué dans le convertisseur numérique-analogique 20.

Le signal filtré par le filtre passe-bas 25 peut être fourni en tant que second signal de tension de commande KVCO_mod à une seconde entrée de l'oscillateur commandé en tension 10. La sensibilité en tension à la seconde entrée de l'oscillateur commandé en tension peut être de l'ordre de 4 MHz/V, ce qui est 100 fois inférieur à la sensibilité de la première entrée indiquée ci-devant. Ceci permet au convertisseur numérique-analogique 20 de travailler avec une plus grande amplitude, tout en ayant des pointes dues à l'injection d'horloge du convertisseur moins importantes.

Pour produire une tension plate à la caractéristique de déviation de fréquence, le varacteur de modulation de l'oscillateur commandé en tension 10 doit être polarisé autour de son gain maximum de travail. La déviation maximum de +500 kHz à 4.9 GHz mène à une approximation suffisamment linéaire de la tension à la caractéristique de fréquence de l'oscillateur commandé en tension 10 pour une sensibilité dans la marge de 4 MHz/V. Dans ce cas, la déviation positive de tension maximum nécessaire pour générer +500 kHz de déviation de fréquence est dans la marge de 125 mV pour le second signal de tension de commande KVCO_mod.

Pour pouvoir calibrer automatiquement le gain du convertisseur numérique-analogique 20, l'accès haute fréquence comprend encore des moyens de calibrage, qui sont mis en fonction pendant l'opération d'auto-calibrage du convertisseur. Les moyens de calibrage sont constitués par une seconde pompe de charges 14 reliée au comparateur de phase 3, un second filtre de boucle passe-bas 15, un comparateur de tension 21 pour comparer la tension sur le second filtre de boucle 15 avec la tension de sortie du convertisseur 20, et une logique de commande 22 en sortie du comparateur pour adapter le gain du convertisseur. Le courant de polarisation typique de la seconde pompe de charges 14 peut être situé au voisinage de 40 pA.

Le second filtre de boucle 15 peut être constitué par un premier condensateur (p. ex. 1 pF) en parallèle avec une résistance (p. ex. 400 kOhm) et un second condensateur (p. ex. 20 pF). La fréquence de coupure d'un tel second filtre peut être de l'ordre de 77 kHz. Pour le comparateur de tension, son écart ou offset devrait être petit, par exemple plus bas que 1 mV permettant d'avoir une petite erreur ajoutée à la déviation de fréquence correspondante. De plus, il devrait avoir une vitesse de balayage (slew rate en terminologie anglaise) suffisamment haute pour ne pas ralentir la phase de calibrage de la logique du convertisseur numérique-analogique. Une topologie à capacités commutées compensées en offset pourrait être utilisée.

Concernant la logique de commande 22, elle peut fournir un gain défini sur 5 bits. Ceci permet d'avoir tous les gains possibles entre 250 kHz et 750 kHz de déviation maximum, ce qui mènera à 8 kHz d'erreur de déviation maximum tout en assumant que le second signal de tension de commande KVCO_mod est linéaire. L'algorithme de décision pourrait être basé sur la méthode de Newton.

Pour l'auto-calibrage du convertisseur, le second filtre de boucle 15 est relié à la seconde entrée de l'oscillateur commandé en tension 10 par l'intermédiaire d'un second multiplexeur 17. Dans ce cas, aucun signal de tension sur le filtre passe-bas 25 relié à une autre entrée du second multiplexeur 17, n'est transmis comme second signal de tension de commande KVCO_mod à la seconde entrée de l'oscillateur commandé en tension 10. Lors de l'opération d'auto-calibrage, une seconde boucle à verrouillage de phase passe-bas est réalisée avec la seconde pompe de charges 14 en fonction, liée au comparateur de phase 3 par deux fils et le second filtre de boucle 15 relié à la seconde entrée de l'oscillateur commandé en tension.

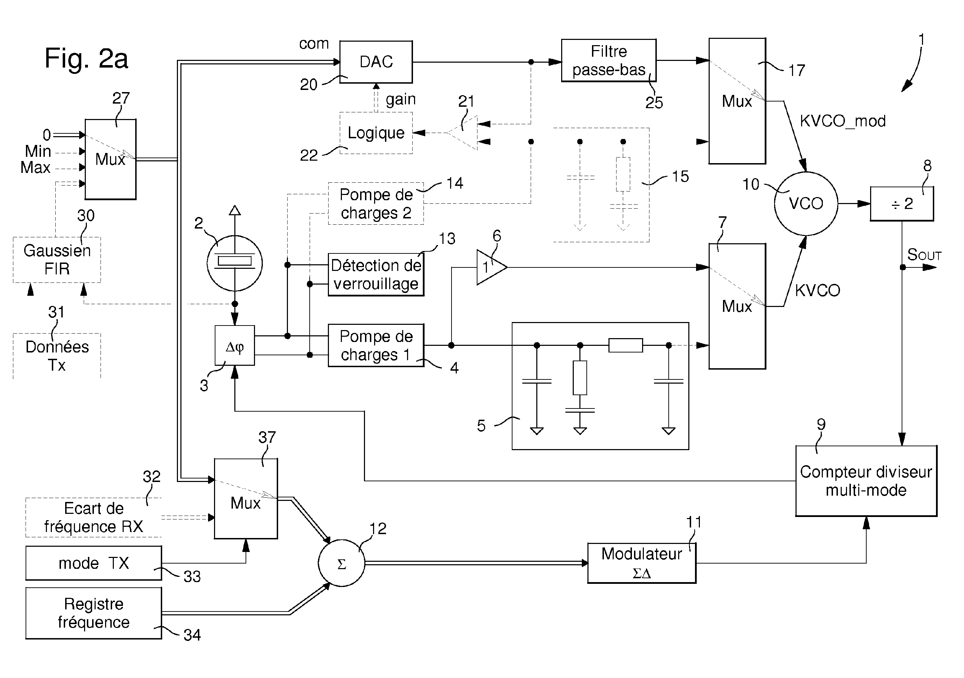

La seconde pompe de charges 14 est donc une partie de moyens de connexion tout comme la première pompe de charges 4. L'une ou l'autre pompe de charges peut être mise en fonction quand l'autre est mise hors fonction pour fermer ou ouvrir l'une ou l'autre boucle à verrouillage de phase comme expliqué ci-dessous en référence aux figures 2a à 2d.

Il peut être prévu également un détecteur de verrouillage 13 relié aux deux fils d'entrée des deux pompes de charges 4, 14 afin de détecter le moment où une des deux boucles à verrouillage de phase en fonction s'est verrouillée sur une fréquence programmée. Cependant, il n'est souvent pas très utile d'utiliser un tel détecteur de verrouillage pour plusieurs raisons notamment dans ledit procédé d'auto-calibrage. Le détecteur de verrouillage peut ne pas être utilisé, car il a un temps de réaction qui peut ne pas être souhaité lors de commutation d'une phase à l'autre dans le procédé d'auto-calibrage. Il n'est utile que lors d'un grand changement de canal de transmission où un grand écart de fréquence est constaté. Une fois que la première boucle à verrouillage de phase s'est verrouillée, le déphasage est très faible ce qui peut être également difficile à détecter. De plus, le temps de verrouillage d'une telle boucle à verrouillage de phase est généralement connu, notamment pour le passage d'un canal de transmission à un autre voisin. De ce fait, il peut est préférable de fixer les temps de commutation (déterministes) d'une phase de calibrage à l'autre.

En verrouillant la seconde boucle à verrouillage de phase sur une fréquence correspondant par exemple à la fréquence porteuse sélectionnée additionnée ou soustraite d'une déviation ou d'un écart de fréquence maximal de modulation désiré, il est possible de calibrer le convertisseur numérique-analogique. Pour ce faire une fois que la seconde boucle à verrouillage de phase s'est verrouillée sur l'une ou l'autre fréquence de sortie de modulation, la tension mémorisée sur le second filtre de boucle 15 est comparée à la tension de sortie du convertisseur 20 par le comparateur de tension 21. Cette tension de sortie du convertisseur dépend d'un mot de commande com fourni à l'entrée du convertisseur pour représenter par exemple l'une ou l'autre fréquence de sortie de modulation souhaitée. Le gain du convertisseur peut être ainsi adapté par la logique de commande 22 qui suit le comparateur de manière à rendre la tension de sortie du convertisseur égale à la tension mémorisée sur le second filtre de boucle. Ce gain est adapté par rapport à une tension de sortie de base du convertisseur en fonction d'un mot de commande représentant par exemple la fréquence porteuse désirée en sortie du synthétiseur.

Lors de la programmation d'une fréquence à synthétiser pour le procédé d'auto-calibrage, le modulateur sigma delta 11 reçoit le même mot de commande que le convertisseur numérique-analogique 20. Pour ce faire, un troisième multiplexeur 37 reçoit en entrée soit le mot de commande com, soit un écart de fréquence 32 dans un mode de réception du transmetteur GFSK. Cet écart de fréquence permet d'effectuer une adaptation de la fréquence à synthétiser en fonction de la fréquence de signaux radiofréquences reçus par le transmetteur.

Ce troisième multiplexeur 37 transmet donc dans le mode de modulation commandé par le mode Tx 33, le mot de commande com à un additionneur 12. Cet additionneur permet d'effectuer l'addition d'un mot relatif à la fréquence d'un canal de transmission désiré provenant d'un registre de fréquence 34, et du mot de commande com.

Chaque mot binaire de commande com pour le convertisseur numérique-analogique 20 ou le modulateur sigma delta 11 est préférentiellement de 4 bits. Chaque mot binaire de commande est fourni à travers un multiplexeur 27, défini multiplexeur de modulation. Normalement, les 4 bits du mot binaire de commande pour l'opération de calibrage du convertisseur sont définis entre -8 à +7, mais pour être symétrique par rapport au 0, il n'est choisi que de -7 à 7. Dans ce cas, le mot binaire 0, qui est prévu pour représenter la fréquence porteuse sélectionnée pour le canal de transmission, est 1000. Le mot binaire Max, pour représenter la déviation maximale de fréquence de modulation à additionner à la fréquence porteuse est le mot binaire 1111. Finalement, le mot binaire Min, pour représenter la déviation maximale de fréquence de modulation à soustraire à la fréquence porteuse, est le mot binaire 0001. Cette configuration est définie par le terme anglais N-signed.

Quand le multiplexeur de modulation 27 est commandé par un signal à 2 bits pour fournir le mot binaire 0 au convertisseur numérique-analogique 20, la tension de sortie de base du convertisseur n'est pas influencée par une modification du gain du convertisseur. Par contre, lorsque le multiplexeur de modulation 27 est commandé pour fournir soit le mot binaire Max, soit le mot binaire Min pour l'opération de calibrage du convertisseur, le gain du convertisseur calibré a une influence directe sur le niveau de la tension de sortie du convertisseur numérique-analogique. Ceci permet par comparaison de tension dans le comparateur de tension 21 d'ajuster l'écart de tension en sortie du convertisseur entre la tension de sortie représentant la fréquence porteuse et la tension de sortie représentant l'une ou l'autre des fréquences de sortie de modulation. De cette manière comme expliqué par la suite en référence aux figures 2a à 2d, il est possible d'égaliser la déviation de fréquence dans la première boucle à verrouillage de phase et dans l'accès haute fréquence pour ne pas avoir de distorsions aux changement d'état lors de la modulation des données.

Lorsque le gain du convertisseur numérique-analogique est calibré automatiquement, il est possible de placer le synthétiseur dans un mode de modulation de données. Pour ce faire, le multiplexeur de modulation 27 est commandé pour être relié à un filtre numérique du type gaussien 30 cadencé par un signal d'horloge fourni par le signal de référence de l'oscillateur de référence 2. Le filtre du type gaussien met en forme un signal de données Tx 31 afin de fournir une succession de mots binaires de commande pouvant changer d'état dans le temps à une fréquence pouvant aller jusqu'à 2 MHz par exemple en fonction des données à transmettre. De ce fait, le convertisseur numérique-analogique doit être assez rapide pour suivre le taux maximum du flux de bits de modulation d'au moins 1 Mbit/sec, et qui peut être au maximum de 2 Mbit/sec.

Il est à noter que la fréquence du signal haute fréquence généré par l'oscillateur commandé en tension 10 vaut le double de la fréquence du signal de sortie haute fréquence S_{OUT}, qui comprend des données modulées en fréquence, en sortie d'un diviseur par deux 8. De ce fait, il doit être prévu de programmer le double de la déviation ou écart de fréquence maximal de modulation Δf et de la fréquence porteuse f₀ pour obtenir la fréquence désirée dans le signal de sortie haute fréquence S_{OUT}. La fréquence porteuse d'un canal de transmission sélectionné, dans le signal de sortie S_{OUT}, peut être de valeur proche de 2.45 GHz avec des données modulées en fréquence, autour de cette fréquence porteuse, à une fréquence d'au moins 1 MHz.

Lorsque la déviation de fréquence de modulation par l'accès haute fréquence n'est pas identique à la déviation de fréquence de modulation par la première boucle à verrouillage de phase avant l'opération de calibrage, il s'ensuit certaines distorsions ou retards de commutation sur le signal de sortie du synthétiseur de fréquence. Pour obtenir une déviation de fréquence lors de la modulation presque constante sur toute la marge de fréquence de la largeur de bande de modulation du synthétiseur, il est nécessaire de calibrer le convertisseur numérique-analogique.

Pour représenter l'écart de déviation de fréquence entre la première boucle à verrouillage de phase et l'accès haute fréquence d'un synthétiseur de fréquence non calibré, il est fait référence aux figures 3a et 3b du spectre des données modulées. Sur ces figures 3a et 3b, il est illustré une première fonction de transfert H₁ de la première boucle à verrouillage de phase et une seconde fonction de transfert H₂ de l'accès haute fréquence. Ces fonctions de transfert peuvent être par exemple exprimées en dB pour la déviation de fréquence divisée par le signal d'entrée. L'amplitude des deux fonctions de transfert doit être égalisée pour calibrer l'accès haute fréquence et la première boucle à verrouillage de phase.

Comme on peut le remarquer par la partie hachurée, la première fonction de transfert H₁ couvre une largeur de bande de modulation basse fréquence (BW_{PLL}) où le premier filtre de boucle à une fréquence de coupure par exemple de l'ordre de 100 kHz. La seconde fonction de transfert H₂ couvre par contre une largeur de bande pouvant aller au-delà de la fréquence maximale de modulation définie par fₘ (1 MHz). Le synthétiseur de fréquence doit être calibré de manière à avoir une largeur de bande de modulation (BW_{mod}) pouvant aller jusqu'à 1 MHz au moins.

L'amplitude maximale de la première fonction de transfert H₁ est représentée inférieure à l'amplitude maximale de la seconde fonction de transfert H₂. Un écart d'amplitude ΔH doit être corrigé de manière à obtenir une amplitude maximale sur toute la largeur de bande de modulation BW_{mod} constante. Une superposition des deux fonctions de transfert est opérée par l'oscillateur commandé en tension où une addition des deux fonctions est effectuée comme montré à la figure 3b.

Aux figures 4a à 4c, il est également représenté des graphiques du changement de fréquence dans le temps par rapport à une fréquence porteuse sélectionnée, correspondant à une modulation de données dans le signal de sortie S_{OUT} du synthétiseur de fréquence calibré ou non. Une combinaison de modulation de données par la première boucle à verrouillage de phase et par l'accès haute est opérée à travers l'oscillateur commandé en tension.

L'état "1" de modulation est défini dans le signal de sortie S_{OUT} par l'addition de la fréquence porteuse f₀ et de la déviation ou l'écart maximal de fréquence de modulation Δf, ce qui donne f₀+Δf. Cet état "1" peut être donné par un mot de commande correspondant au mot Max au convertisseur numérique-analogique et au modulateur sigma delta.

L'état "0" de modulation est défini dans le signal de sortie S_{OUT} par la soustraction de la fréquence porteuse f₀ par la déviation ou l'écart maximal de fréquence de modulation Δf, ce qui donne f₀-Δf. Cet état "0" peut être donné par un mot de commande correspondant au mot Min au convertisseur numérique-analogique et au modulateur sigma delta.

Dans le cas où l'amplitude maximale de la seconde fonction de transfert est plus grande que l'amplitude maximale de la première fonction de transfert comme montré par les figures 3a et 3b, les transitions haute fréquence sont accentuées par rapport aux transitions basse fréquence comme montré à la figure 4a. Il y a donc trop de gain dans le convertisseur numérique-analogique. La fréquence maximale de changement d'état de modulation est défini par 1/Tc.

Dans le cas contraire où l'amplitude maximale de la première boucle à verrouillage de phase est plus grande que celle de l'accès haute fréquence, les transitions d'état sont relativement lentes comme montré à la figure 4b. Il n'y a donc pas assez de gain dans le convertisseur numérique-analogique.

Une fois que le gain du convertisseur numérique-analogique a été calibré comme expliqué ci-après en référence aux figures 2a à 2d, aucune distorsion ou retard de commutation sur le signal de sortie n'est constaté sur toute la largeur de bande de modulation comme montré à la figure 4c.

Bien entendu en lieu et place des figures 4a à 4c, il aurait été possible de représenter un diagramme défini en oeil pour montrer l'état non calibré entre la première boucle et l'accès haute fréquence avec le convertisseur numérique-analogique. Un calibrage effectué montrerait une maximisation de l'ouverture de l'oeil, alors qu'un non calibrage selon la figure 4a ou 4b montrerait une forme d'oeil aplatie selon l'un ou l'autre des axes du diagramme.

En référence aux figures 2a à 2d, il est expliqué toutes les phases ou étapes du procédé d'auto-calibrage du synthétiseur de fréquence 1 de manière à égaliser le niveau d'amplitude du spectre des données modulées par le convertisseur numérique-analogique 20 combiné avec la première boucle à verrouillage de phase basse fréquence. Il est à noter que sur chacune de ces figures, les différentes parties du synthétiseur, qui sont soit au repos, soit mises hors fonction sont représentées en traits interrompus. De cette manière, il est plus facile de comprendre les différentes phases pour le calibrage automatique du convertisseur numérique-analogique, jusqu'à la phase de modulation des données proprement dite. Comme tous les éléments du synthétiseur de fréquence 1 ont été déjà décrits en référence à la figure 1, ils ne seront donc plus explicités en détail.

A la figure 2a, il est représenté la première phase ou étape du procédé d'auto-calibrage du synthétiseur de fréquence 1. Dans cette première phase, la première boucle à verrouillage de phase doit être verrouillée à la fréquence porteuse f₀ d'un canal de transmission sélectionné.

Le multiplexeur de modulation 27 est commandé pour fournir le mot binaire de commande 0 pour représenter la fréquence porteuse f₀. Ce mot binaire 0 est fourni au convertisseur numérique-analogique 20, ainsi qu'au modulateur sigma delta 11 par l'intermédiaire du multiplexeur 37 et l'additionneur 12. Le modulateur sigma delta reçoit également un mot de fréquence provenant d'un registre de fréquence 34 pour pouvoir définir la fréquence porteuse f₀ à synthétiser par la première boucle à verrouillage de phase.

Dans cette première phase, la première pompe de charges 4 est en fonction, alors que la seconde pompe de charges 14 est déconnectée. De plus, le premier multiplexeur 7 est commandé pour relier la sortie du suiveur de tension unitaire 6 à la première entrée du varacteur principal de l'oscillateur commandé en tension. De cette manière, la tension mémorisée sur le premier filtre de boucle 5 est transmise à travers le suiveur de tension 6 pour fournir le premier signal de tension de commande KVCO.

Le second multiplexeur 17 est commandé pour relier la sortie du filtre passe-bas 25 à la seconde entrée de modulation de l'oscillateur commandé en tension 10. Le convertisseur numérique-analogique 20 fournit donc à travers le filtre passe-bas et le second multiplexeur 17 le second signal de tension de commande dont le niveau est fonction du mot de commande com, qui est dans ce cas le mot binaire 0. Avec ce mot binaire 0, le niveau de cette première tension de sortie de base dudit convertisseur ne change pas avec un changement du gain dudit convertisseur.

En guise de rappel étant donné la fréquence de coupure basse de la première boucle à verrouillage de phase, une modulation en fréquence de données par exemple à 1 ou 2 Mbit/sec ne peut être effectuée par la première boucle basse fréquence. Ceci est dû également au fait que la fréquence de référence de l'oscillateur de référence se situe entre 16 et 26 MHz, et qu'il serait nécessaire d'avoir plutôt une fréquence de l'ordre de 150 MHz pour avoir une boucle suffisamment rapide. Toutefois avec une fréquence de référence à 150 MHz, il n'est pas possible de réduire la consommation électrique du synthétiseur de fréquence, alors que la réduction de consommation peut être escomptée.

Si la fréquence de coupure est fixée aussi basse dans cette boucle à verrouillage de phase basse fréquence, c'est principalement dû au bruit généré par le modulateur sigma delta, qu'il faut supprimer. Cependant avec une fréquence de coupure de l'ordre de 100 kHz, le synthétiseur de fréquence est approximativement 10 fois trop lent avec la fréquence de référence à 16 MHz.

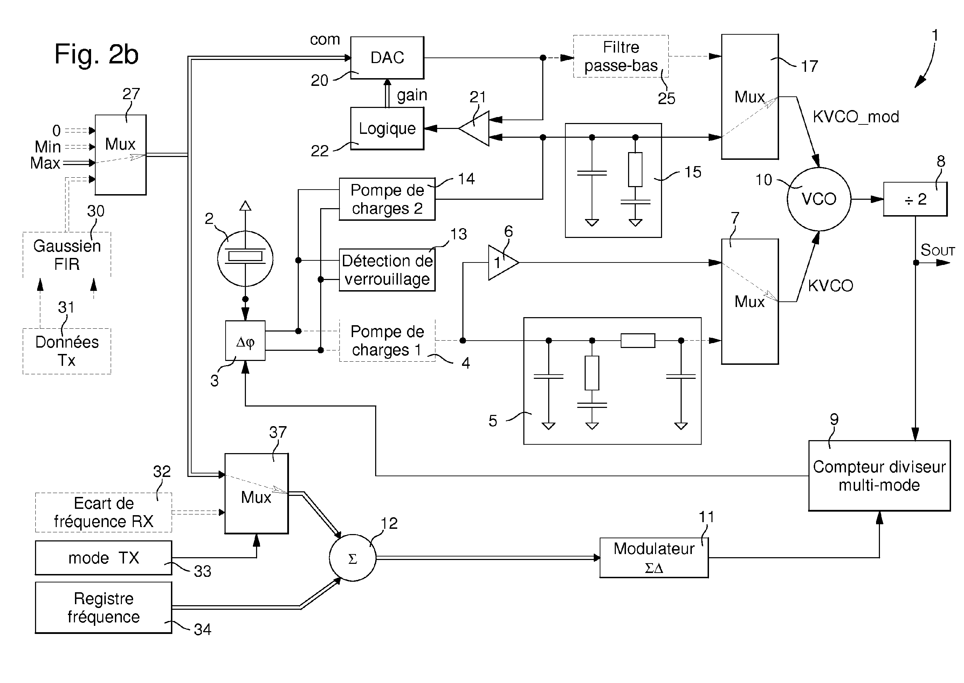

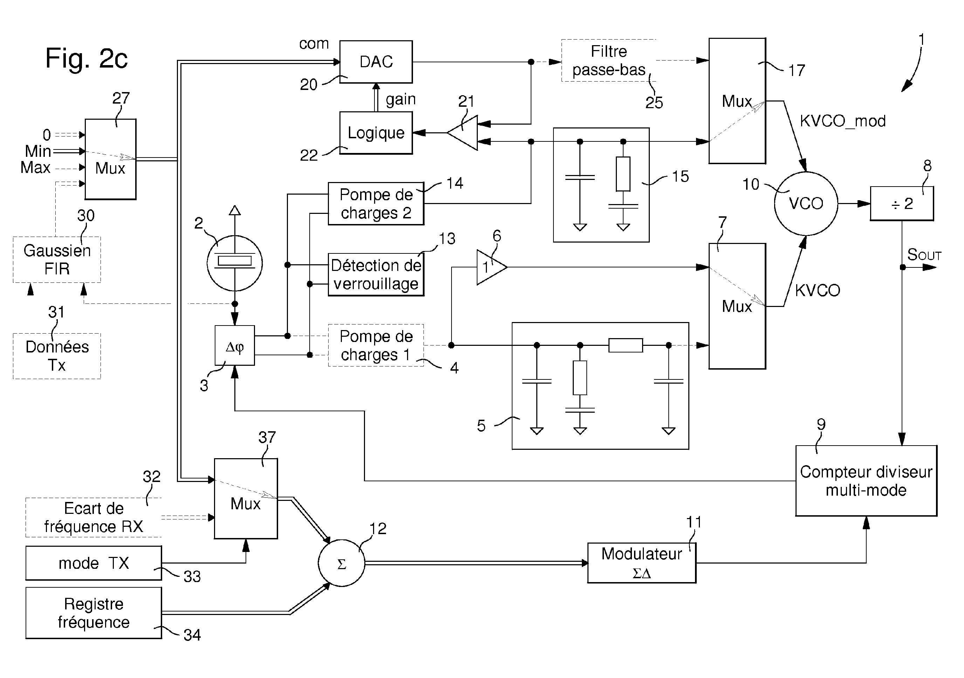

Si on souhaite moduler des données en fréquence à une fréquence de 1 MHz sur le signal de sortie S_{OUT}, il est nécessaire d'augmenter la largeur de bande à 1 MHz à la suite de la première pompe de charges. Cette rapidité de la boucle basse fréquence n'est pas escomptée avec un quartz de l'oscillateur à fréquence si basse. Pour les transitions haute fréquence, il est donc utilisé en plus l'accès haute fréquence pour l'oscillateur commandé en tension. La différence de fréquence pour la modulation de fréquence est asservie par la première boucle à verrouillage de phase, où un petit écart de tension conduit à une grande différence de fréquence. Il faut donc donner un gain précis au convertisseur numérique-analogique afin d'égaliser le niveau d'amplitude du spectre de données modulées dans le première boucle et par l'accès haute fréquence, ce qui est décrit ci-dessous en référence notamment aux figures 2b et 2c.

Grâce à l'accès haute fréquence par l'intermédiaire du convertisseur numérique-analogique, ledit convertisseur va pouvoir injecter les fortes transitions d'état dans la modulation de fréquence en combinaison de la première boucle basse fréquence plus précise. S'il y a un rapide passage d'un état à l'autre des données modulées, il n'y a aucune distorsion ou retard constaté sur le signal de sortie, par le convertisseur numérique-analogique s'il est calibré, ce qui est souhaité.

Une détection du verrouillage par un détecteur de verrouillage 13 peut permettre de déterminer l'instant où la première boucle à verrouillage de phase s'est verrouillée à la fréquence porteuse sélectionnée. Une fois détectée, il peut être passé à la seconde phase du procédé d'auto-calibrage représentée à la figure 2b. Cependant comme indiqué précédemment, le temps de verrouillage d'une telle boucle à verrouillage de phase est en général connu et peut être fixé ou programmé pour le passage automatique de la première phase à la seconde phase du procédé d'auto-calibrage.

A la figure 2b, il est représenté la seconde phase ou étape du procédé d'auto-calibrage du synthétiseur de fréquence 1. Dans cette seconde phase, la première pompe de charges 4 doit être déconnectée pour ouvrir la première boucle à verrouillage de phase, alors que la seconde pompe de charges 14 doit être mise en fonction pour former avec le second filtre de boucle 15 une seconde boucle à verrouillage de phase.

Il faut également prendre garde, dans la seconde phase du procédé, de ne pas déconnecter brutalement la première pompe de charges 4, car il peut subsister une légère erreur de tension constante mémorisée sur le premier filtre de boucle 5, ce qui peut conduire à une erreur de calibrage du convertisseur numérique-analogique par la suite. De ce fait, il serait préférable de couper progressivement la première pompe de charges pour éviter de telles erreurs. Il faut environ 60 cycles avant son extinction.

Dans cette seconde phase, la tension mémorisée sur le premier filtre de boucle 5 représentant la fréquence porteuse sélectionnée, est transmise par l'intermédiaire du suiveur de tension unitaire 6 et du premier multiplexeur 7 en tant que premier signal de tension de commande KVCO à la première entrée de l'oscillateur commandé en tension. Cette tension mémorisée représente le premier signal de tension de commande KVCO. Comme indiqué précédemment, le suiveur de tension permet de compenser la perte de courant de l'oscillateur commandé en tension de manière à conserver une tension constante sur le premier filtre de boucle 5.

Le second multiplexeur 17 est commandé pour relier le second filtre de boucle 15 à la seconde entrée de l'oscillateur commandé en tension pour fermer une seconde boucle à verrouillage de phase. Cette seconde boucle à verrouillage de phase doit être verrouillée dans cette seconde phase à une première fréquence de sortie du synthétiseur f₀+Δf, qui doit correspondre à l'addition de la fréquence porteuse f₀ à une déviation ou un écart de fréquence maximal de modulation Δf. Pour ce faire, le multiplexeur de modulation 27 doit être commandé pour fournir le mot binaire Max au convertisseur numérique-analogique 20 et au modulateur sigma delta 11.

La tension mémorisée sur le second filtre de boucle 15 est fournie en tant que troisième signal de tension de commande à la seconde entrée de l'oscillateur commandé en tension 10, qui est à un second niveau de tension. Cette tension mémorisée sur le second filtre 15 va permettre de calibrer automatiquement le convertisseur numérique-analogique 20. Pour ce faire, un comparateur de tension 21 en fonction compare la tension de sortie du convertisseur 20, qui a reçu le mot binaire Max, avec la tension mémorisée sur le second filtre de boucle 15. Une fois que la seconde boucle à verrouillage de phase s'est verrouillée sur la première fréquence de sortie désirée, le comparateur de tension 21 agit sur une logique de commande 22. Cette logique de commande permet de calibrer le gain du convertisseur jusqu'à ce que la tension de sortie du convertisseur 20 soit identique à la tension mémorisée sur le second filtre de boucle 15 à un second niveau de tension.

L'écart en tension entre le premier niveau de tension et le second niveau de tension en sortie du convertisseur numérique-analogique 20 est représentatif de la déviation ou écart de fréquence maximal de modulation Δf à calibrer par rapport à la première boucle à verrouillage de phase.

A la figure 2c, il est représenté la troisième phase ou étape du procédé d'auto-calibrage du synthétiseur de fréquence 1. Cette troisième phase n'est pas forcément nécessaire pour l'opération de calibrage du synthétiseur de fréquence. Cependant, cette troisième phase permet de mieux linéariser le synthétiseur de fréquence.

Dans cette troisième phase, la première pompe de charges 4 reste déconnectée laissant ouverte la première boucle à verrouillage de phase, alors que la seconde pompe de charges 14 est toujours en fonction pour former avec le second filtre de boucle 15 la seconde boucle à verrouillage de phase. Cette seconde boucle à verrouillage de phase doit être verrouillée cette fois à une seconde fréquence de sortie du synthétiseur f₀ Δf, qui doit correspondre à la soustraction de la fréquence porteuse f₀ par une déviation ou un écart de fréquence maximal de modulation Δf. Pour ce faire, le multiplexeur de modulation 27 doit être commandé pour fournir le mot binaire Min au convertisseur numérique-analogique 20 et au modulateur sigma delta 11.

La tension mémorisée sur le second filtre de boucle 15 est cette fois à un troisième niveau de tension. Cette tension mémorisée est comparée dans le comparateur de tension 21 à la tension de sortie du convertisseur numérique-analogique, qui a reçu le mot binaire Min. La sortie du comparateur de tension 21 agit sur la logique de commande 22 pour adapter le gain du convertisseur 20 afin de rendre identique la tension de sortie du convertisseur et la tension mémorisée sur le second filtre de boucle 15. Cette nouvelle adaptation du gain du convertisseur peut permettre de supprimer certains défauts de non linéarité dans le synthétiseur de fréquence.

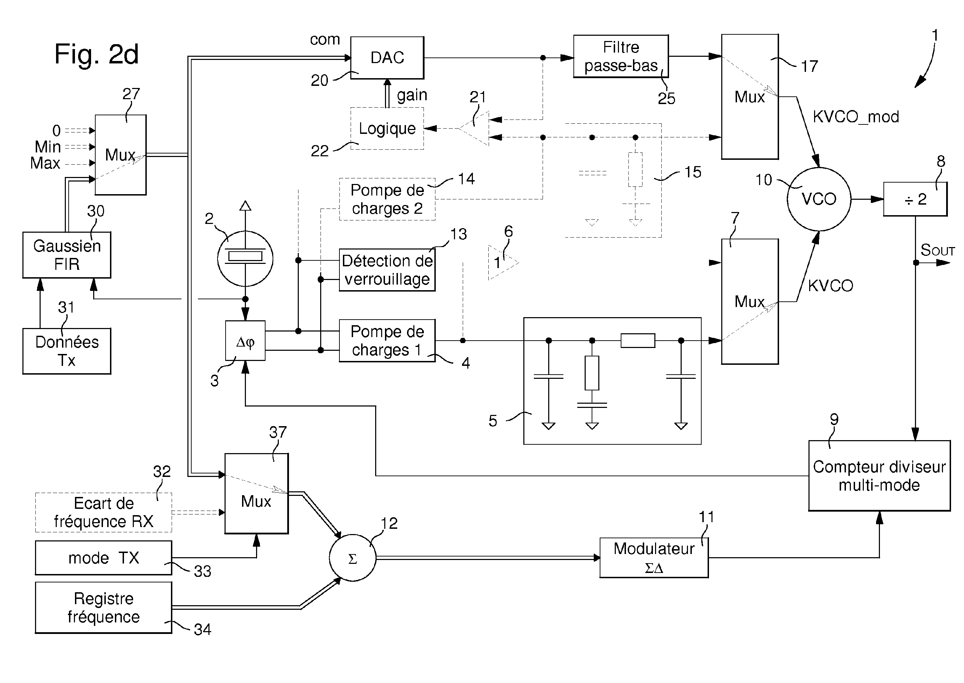

Finalement à la figure 2d, il est représenté une phase de modulation au terme du procédé d'auto-calibrage du synthétiseur de fréquence 1 dès que ledit synthétiseur de fréquence est calibré.

Dans cette phase de modulation, la seconde pompe de charges 14 est déconnectée, et la première pompe de charges 4 est de nouveau remise en fonction. Toutefois, dans cette phase de modulation, le suiveur de tension unitaire 6 doit être déconnecté. De ce fait, le premier multiplexeur 7 est commandé pour relier directement le premier filtre de boucle 5 à la première entrée de l'oscillateur commandé en tension 10.

Du côté de l'accès haute fréquence, le second multiplexeur 17 est commandé pour relier le filtre passe-bas anti-repliement 25 directement à la seconde entrée de l'oscillateur commandé en tension 10. Un second signal de tension de commande KVCO_mod peut être fourni par le convertisseur numérique-analogique 20.

Le modulateur de modulation 27 est commandé cette fois pour fournir en sortie une succession de mots de commande provenant du filtre numérique du type gaussien 30 sur la base de données Tx 31 à moduler dans le signal de sortie haute fréquence S_{OUT}. Cette succession de mots de commande est fournie aussi bien au convertisseur 20, qu'au modulateur sigma delta 11 par l'intermédiaire du multiplexeur 37 et de l'additionneur 12. Comme le gain du convertisseur 20 est calibré, la combinaison de la première boucle à verrouillage de phase avec l'accès haute fréquence permet d'obtenir un signal de sortie haute fréquence sans aucune distorsion ou retard de commutation de la modulation de données.

A partir de la description qui vient d'être faite, plusieurs variantes du procédé d'auto-calibrage du synthétiseur et du synthétiseur pour sa mise en oeuvre peuvent être conçues par l'homme du métier sans sortir du cadre de l'invention définie par les revendications. Dans les moyens de connexion, les pompes de charges pourraient être remplacées par des interrupteurs, mais la structure d'une pompe de charges est relativement plus simple et plus rapide qu'une structure d'interrupteur. La sensibilité aux deux entrées de l'oscillateur commandé en tension peut être modifiée. Il peut être prévu deux ou plusieurs convertisseurs numériques-analogiques à calibrer et à relier à une seconde entrée de l'oscillateur commandé en tension. La fréquence de l'oscillateur de référence peut être modifiée ou adaptée. Finalement, l'oscillateur commandé en tension peut générer en sortie deux signaux haute fréquence en opposition de phase.

## Revendications

1. Procédé d'auto-calibrage d'un synthétiseur de fréquence (1) susceptible d'opérer une modulation de fréquence à deux points pour la transmission de données, le synthétiseur de fréquence comprenant :
- une première boucle à verrouillage de phase basse fréquence dans laquelle sont placés un oscillateur de référence (2), un comparateur de phase (3) relié à l'oscillateur de référence, un premier filtre de boucle passe-bas (5), un oscillateur commandé en tension (10) relié par une première entrée dans la première boucle basse fréquence pour recevoir un premier signal de tension de commande (KVCO) par l'intermédiaire du premier filtre passe-bas, un compteur diviseur multi-mode (9) commandé par un modulateur (11) pour diviser en fréquence un signal de sortie haute fréquence (S_{OUT}) sur la base d'un signal haute fréquence produit par l'oscillateur commandé en tension, afin de fournir un signal divisé à comparer à un signal de référence de l'oscillateur de référence dans le comparateur de phase, et
- un accès haute fréquence dans lequel est placé un convertisseur numérique-analogique (20) pour fournir un second signal de tension de commande (KVCO_mod) à une seconde entrée de l'oscillateur commandé en tension (10) pour la modulation de données haute fréquence,
le procédé d'auto-calibrage étant **caractérisé en ce qu'**il comprend les étapes de :
a) dans une première phase, verrouiller la première boucle à verrouillage de phase passe-bas sur un canal de transmission à fréquence porteuse déterminée (f₀) en sortie du synthétiseur, et fournir un premier mot de commande (0, com) au convertisseur dans l'accès haute fréquence correspondant à la fréquence porteuse déterminée pour générer un second signal de tension de commande pour l'oscillateur commandé en tension, à un premier niveau de tension de base,
b1) dans une seconde phase, ouvrir la première boucle à verrouillage de phase tout en maintenant par le premier filtre de boucle un premier signal de tension de commande correspondant à la fréquence porteuse déterminée pour la première entrée de l'oscillateur commandé en tension, et verrouiller une seconde boucle à verrouillage de phase, qui comprend un second filtre de boucle passe-bas (15) dans l'accès haute fréquence relié entre le comparateur de phase (3) de la première boucle et la seconde entrée de l'oscillateur commandé en tension, à une première fréquence de sortie (f₀+Δf) égale à la fréquence porteuse additionnée à un écart de fréquence maximal de modulation,
b2) fournir au convertisseur numérique-analogique, dans la deuxième phase, un second mot de commande (Max, com) pour représenter la première fréquence de sortie (f₀+Δf), et comparer la tension de sortie du convertisseur avec la tension mémorisée sur le second filtre de boucle pour calibrer automatiquement le gain du convertisseur afin que la tension de sortie du convertisseur soit équivalente à la tension mémorisée sur le second filtre à un second niveau de tension, dont l'écart avec le premier niveau de tension de base définit l'écart de fréquence maximal de modulation égalisé, et
c) dans une phase de modulation, ouvrir la seconde boucle à verrouillage de phase et fermer la première boucle à verrouillage de phase pour la modulation de données à deux points par l'oscillateur commandé en tension à l'aide d'une succession dans le temps de mots de commande (30, 31) fournie au convertisseur numérique-analogique calibré et au modulateur de la première boucle à verrouillage de phase.

2. Procédé d'auto-calibrage selon la revendication 1, **caractérisé en ce qu'**il comprend une troisième phase entre l'étape b2) et l'étape c), dans laquelle la seconde boucle à verrouillage de phase fermée est verrouillée sur une seconde fréquence de sortie (f₀-Δf) égale à la soustraction de la fréquence porteuse par l'écart de fréquence maximal de modulation, **en ce qu'**un troisième mot de commande (Min, com) pour représenter la seconde fréquence de sortie est fourni au convertisseur numérique-analogique (20), et **en ce que** la tension de sortie du convertisseur est comparée à la tension mémorisée sur le second filtre de boucle pour calibrer automatiquement le gain du convertisseur afin que la tension de sortie du convertisseur soit équivalente à la tension mémorisée sur le second filtre à un troisième niveau de tension, dont l'écart avec le premier niveau de tension de base définit l'écart de fréquence maximal de modulation égalisé.

3. Procédé d'auto-calibrage selon l'une des revendications précédentes, pour lequel la première boucle à verrouillage de phase comprend une première pompe de charges (4) entre le comparateur de phase (3) et le premier filtre de boucle (5), et la seconde boucle à verrouillage de phase comprend une seconde pompe de charges (14) entre le comparateur de phase (3) et le second filtre de boucle (15), **caractérisé en ce que** l'ouverture ou la fermeture de la première boucle à verrouillage de phase est réalisée par l'intermédiaire de la première pompe de charges, et **en ce que** l'ouverture ou la fermeture de la seconde boucle à verrouillage de phase est réalisée par l'intermédiaire de la seconde pompe de charges.

4. Procédé d'auto-calibrage selon la revendication 3, **caractérisé en ce que** la première pompe de charges est progressivement déconnectée pour l'ouverture de la première boucle à verrouillage de phase dans la deuxième phase, lors de la fermeture de la seconde boucle à verrouillage de phase par la mise en fonction de la seconde pompe de charges.

5. Procédé d'auto-calibrage selon l'une des revendications précédentes, **caractérisé en ce que** dans les première et seconde phases, le premier signal de tension de commande est fourni par un suiveur de tension unitaire (6) relié en entrée du premier filtre de boucle.

6. Procédé d'auto-calibrage selon la revendication 5, pour lequel un premier multiplexeur (7) est disposé entre la première entrée de l'oscillateur commandé en tension (10) et la sortie du premier filtre de boucle (5) et du suiveur de tension unitaire (6), **caractérisé en ce que** dans les première, deuxième ou troisième phases, le premier multiplexeur (7) est commandé pour relier le suiveur de tension à la première entrée de l'oscillateur commandé en tension, alors que dans la phase de modulation, le premier multiplexeur est commandé pour relier le premier filtre passe-bas à la première entrée de l'oscillateur commandé en tension.

7. Procédé d'auto-calibrage selon l'une des revendications précédentes, pour lequel un second multiplexeur (17) est disposé entre la seconde entrée de l'oscillateur commandé en tension et une sortie du second filtre de boucle (15) et d'un filtre passe-bas anti-repliement (25) relié au convertisseur numérique-analogique (20), **caractérisé en ce que** dans la première phase et la phase de modulation, le second multiplexeur (17) est commandé pour relier la seconde entrée de l'oscillateur commandé en tension au filtre anti-repliement (25) pour la fourniture du second signal de tension de commande, et **en ce que** dans les deuxième ou troisième phases, le second multiplexeur est commandé pour relier la seconde entrée de l'oscillateur commandé en tension au second filtre de boucle pour recevoir un troisième signal de tension de commande.

8. Procédé d'auto-calibrage selon l'une des revendications précédentes, pour lequel un détecteur de verrouillage (13) est connecté en sortie du comparateur de phase (3), **caractérisé en ce que** le passage de la première phase à la deuxième phase est effectuée dès la détection du verrouillage de la première boucle à verrouillage de phase à la fréquence porteuse programmée par le détecteur de verrouillage.

9. Procédé d'auto-calibrage selon l'une des revendications précédentes, **caractérisé en ce que** les étapes de calibrage du convertisseur numérique-analogique sont effectuées dès la mise en fonction du synthétiseur ou dans un mode de fonctionnement du synthétiseur au terme de chaque période de fonctionnement programmée.

10. Synthétiseur de fréquence (1) pour la mise en oeuvre du procédé d'auto-calibrage selon l'une des revendications précédentes, le synthétiseur de fréquence étant susceptible d'opérer une modulation de fréquence à deux points pour la transmission de données, ledit synthétiseur de fréquence comprenant :
- une première boucle à verrouillage de phase basse fréquence dans laquelle sont placés un oscillateur de référence (2), un comparateur de phase (3) relié à l'oscillateur de référence, un premier filtre de boucle passe-bas (5) relié au comparateur de phase par l'intermédiaire de moyens de connexion (4, 14), un oscillateur commandé en tension (10) relié par une première entrée dans la première boucle basse fréquence pour recevoir un premier signal de tension de commande (KVCO) par l'intermédiaire du premier filtre passe-bas, un compteur diviseur multi-mode (9) commandé par un modulateur (11) pour diviser en fréquence un signal de sortie haute fréquence (S_{OUT}) sur la base d'un signal haute fréquence produit par l'oscillateur commandé en tension, afin de fournir un signal divisé à comparer à un signal de référence de l'oscillateur de référence dans le comparateur de phase, et
- un accès haute fréquence dans lequel est placé un convertisseur numérique-analogique (20) pour fournir un second signal de tension de commande (KVCO_mod) à une seconde entrée de l'oscillateur commandé en tension (10) pour la modulation de données haute fréquence, le synthétiseur de fréquence étant **caractérisé en ce qu'**il comprend un second filtre de boucle (15) dans l'accès haute fréquence susceptible d'être relié par l'intermédiaire des moyens de connexion (4, 14) entre le comparateur de phase (3) de la première boucle et la seconde entrée de l'oscillateur commandé en tension (10) afin de constituer une seconde boucle à verrouillage de phase basse fréquence pour une opération de calibrage du convertisseur numérique-analogique, et **en ce que** l'accès haute fréquence comprend un comparateur de tension (21) pour comparer une tension de sortie du convertisseur numérique-analogique (20) avec une tension sur le second filtre de boucle, lorsque la seconde boucle à verrouillage de phase est verrouillée sur une fréquence de sortie déterminée, afin d'ajuster automatiquement le gain du convertisseur numérique-analogique.

11. Synthétiseur de fréquence (1) selon la revendication 10, **caractérisé en ce que** les moyens de connexion comprennent une première pompe de charges (4) reliée entre le comparateur de phase (3) et le premier filtre de boucle (5), et une seconde pompe de charges (14) reliée entre le comparateur de phase et le second filtre de boucle (15).

12. Synthétiseur de fréquence (1) selon l'une des revendications 10 et 11, **caractérisé en ce qu'**il comprend une logique de commande (22) dans l'accès haute fréquence pour recevoir un signal de sortie du comparateur de tension (21) afin de fournir un mot binaire d'ajustement du gain au convertisseur numérique-analogique (20).

13. Synthétiseur de fréquence (1) selon l'une des revendications 10 à 12, **caractérisé en ce qu'**il comprend un suiveur de tension unitaire (6) dans la première boucle à verrouillage de phase, dont une entrée est reliée à une entrée du premier filtre de boucle, et une sortie du suiveur de tension est susceptible d'être reliée à la première entrée de l'oscillateur commandé en tension.

14. Synthétiseur de fréquence (1) selon la revendication 13, **caractérisé en ce qu'**il comprend un premier multiplexeur (7) disposé entre la première entrée de l'oscillateur commandé en tension (10) et la sortie du premier filtre de boucle (5) et du suiveur de tension unitaire (6), le premier multiplexeur étant commandé pour relier le suiveur de tension ou le premier filtre de boucle à la première entrée de l'oscillateur commandé en tension.

15. Synthétiseur de fréquence (1) selon l'une des revendications 10 à 14, **caractérisé en ce qu'**il comprend un diviseur par deux (8) relié en sortie de l'oscillateur commandé en tension pour fournir un signal de sortie haute fréquence (S_{OUT}) du synthétiseur, le signal de sortie étant divisé par le compteur diviseur double-mode commandé par un modulateur sigma delta dans la première ou la seconde boucle à verrouillage de phase.

16. Synthétiseur de fréquence (1) selon l'une des revendications 10 à 15, **caractérisé en ce qu'**il comprend un second multiplexeur (17) disposé entre la seconde entrée du l'oscillateur commandé en tension (10) et une sortie du second filtre de boucle (15) et d'un filtre passe-bas anti-repliement (25) relié au convertisseur numérique-analogique (20), le second multiplexeur étant commandé pour relier le filtre anti-repliement ou le second filtre de boucle à la seconde entrée de l'oscillateur commandé en tension.

17. Synthétiseur de fréquence (1) selon l'une des revendications 10 et 13, **caractérisé en ce** la première boucle à verrouillage de phase comprend une double structure différentielle composée chacune d'un premier filtre de boucle et d'un suiveur de tension unitaire en parallèle pour relier soit les sorties des deux suiveurs de tension unitaires, soit les sorties des deux premiers filtres de boucle à la première entrée différentielle de l'oscillateur commandé en tension.

18. Synthétiseur de fréquence (1) selon l'une des revendications 10 à 17, **caractérisé en ce qu'**il comprend un multiplexeur de modulation (27) pour fournir au moins un mot de commande d'une fréquence de modulation au convertisseur numérique-analogique (20) et à un modulateur sigma delta pour commander le compteur diviseur multi-mode de la première ou seconde boucle à verrouillage de phase.
